## Europäisches Patentamt

## European Patent Office

## Office européen des brevets

(19)

(11) Veröffentlichungsnummer: **0 278 567**

**A2**

(12)
# EUROPÄISCHE PATENTANMELDUNG

(21) Anmeldenummer: **88200198.5**

(51) Int. Cl.⁴: **H05K 9/00**

(22) Anmeldetag: **04.02.88**

(30) Priorität: **07.02.87 DE 3703787**

(43) Veröffentlichungstag der Anmeldung:
**17.08.88 Patentblatt 88/33**

(84) Benannte Vertragsstaaten:
**DE FR GB IT**

(71) Anmelder: **Philips Patentverwaltung GmbH**
**Wendenstrasse 35 Postfach 10 51 49**
**D-2000 Hamburg 1(DE)**

(84) **DE**

(71) Anmelder: **N.V. Philips' Gloeilampenfabrieken**
**Groenewoudseweg 1**
**NL-5621 BA Eindhoven(NL)**

(84) **FR GB IT**

(72) Erfinder: **Elsner, Hans**
**Auf den Roden 7A**
**D-2800 Bremen 44(DE)**
Erfinder: **Kandler, Wilfried**
**Heidacker 13c**
**D-2807 Achim(DE)**
Erfinder: **Prendel, Peter**
**Wiesenstrasse 14**
**D-2803 Weyhe(DE)**
Erfinder: **Sandkuhl, Jürgen**
**Kiefernstrasse 1**
**D-2803 Weyhe-Leeste(DE)**

(74) Vertreter: **Poddig, Dieter, Dipl.-Ing. et al**
**Philips Patentverwaltung GmbH**
**Wendenstrasse 35 Postfach 10 51 49**
**D-2000 Hamburg 1(DE)**

(54) **Elektromagnetische Dichtungsanordnung.**

(57) Zwischen den Flächen zweier aufeinanderliegender Teile eines Gehäuses für elektronische Geräte wird in einer Nut in einem der Gehäuseteile eine Dichtungsschnur, die mindestens an der Oberfläche aus einem Drahtgewirk besteht, eingelegt, um eine hochfrequenzmäßige Dichtung zu erreichen. Diese Dichtungsschnur wird von einem längeren Stück auf Maß abgeschnitten, und an den Schnittstellen können sich lose Drahtteile des Gewirks bilden, die nach dem Einlegen der Dichtungsschnur in das Gehäuse mit der elektronischen Schaltung fallen und dort Kurzschlüsse auslösen können. Um dies zu verhindern, werden die Enden der Dichtungsschnur in Sacklöcher gesteckt, die in der Nut angebracht sind. Dabei kann die Nut im Bereich der Sacklöcher verbreitert sein, so daß die beiden Enden der Dichtungsschnur auf einem kurzen Stück parallel verlaufen. Zum besseren Fixieren der Enden und zum zuverlässigen Verhindern des Herausfallens von Drahtenden können die Sacklöcher mit Klebstoff versehen sein.

Fig.3

## "Elektromagnetische Dichtungsanordnung"

Die Erfindung betrifft eine Dichtungsanordnung aus einem strangförmigen elastischen Dichtungskörper mit im wesentlichen konstantem Querschnitt, der mindestens an der Oberfläche aus einem leitenden Drahtgeflecht, insbesondere einem auftragenden Gewirk besteht, und der von einem längeren Stück abgeschnitten ist und der zwischen zwei Gehäuseteilen in einer in der Oberfläche des einen Gehäuseteils angebrachten Nut eingelegt ist.

Derartige Dichtungsanordnungen werden verwendet, um Gehäuse, die elektronische Schaltungen enthalten, hochfrequenzmäßig dicht zu verschließen. Dabei besteht der strangförmige, weichelastische Dichtungskörper üblicherweise durchgehend aus einem Strang aus einem Drahtgewirk oder aus einem Schlauch aus Drahtgewirk, der auf einem Strang aus elastischem Material aufgebracht ist. Ein derartiger Dichtungskörper wird üblicherweise von einem längeren Stück genau auf Maß abgeschnitten und dann in die Nut des einen Gehäuseteils eingelegt. Beim Abschneiden eines Dichtungskörpers aus Drahtgewirk ergeben sich an den Schnittenden freie Drahtstücke, die zunächst noch im umgebenden Gewirk gehalten werden, die sich jedoch unkontrolliert lösen können und dann in das Innere des Gehäuses mit einer elektronischen Schaltung gelangen können, wo sie Kurzschlüsse hervorrufen können. Dies kann beispielsweise auch geschehen, wenn das Gehäuse bereits verschlossen war und später zu Wartungs-oder Reparaturzwecken wieder geöffnet werden muß, denn auch dann können sich noch freie Drahtenden aus dem Gewirk lösen.

Aufgabe der Erfindung ist es, eine Dichtungsanordnung der eingangs genannten Art anzugeben, bei der zuverlässig verhindert wird, daß sich freie Drahtenden von den Schnittenden des Dichtungskörpers aus Drahtgewirk lösen können.

Diese Aufgabe wird dadurch gelöst, daß die beiden Enden des Dichtungskörpers in je einem im wesentlichen senkrecht zur Oberfläche des einen Gehäuseteils gerichteten Sackloch im Bereich der Nut eingesteckt sind.

Durch die erfindungsgemäße Maßnahme werden nun eventuell sich lösende freie Drahtenden in dem Sackloch gehalten und können damit nicht mehr in das Innere des Gehäuses gelangen.

Häufig werden Dichtungsanordnungen mit einer Nut mit ringförmig geschlossenem Verlauf verwendet, um auf diese Weise an jeder Stelle eine hochfrequenzmäßige Dichtung zu erreichen. In diesem Falle ist es nach einer Ausgestaltung der Erfindung zweckmäßig, daß die Sacklöcher unmittelbar hintereinander in der Nut angeordnet sind. Die eingesteckten Enden des Dichtungskörpers berühren sich dann und ergeben einen weitgehend hochfrequenzmäßig dichten Übergang zwischen den beiden Enden des Dichtungskörpers. Eine weitere Verbesserung ist jedoch nach einer anderen Ausgestaltung der Erfindung dadurch gekennzeichnet, daß die Nut in einem Bereich auf etwa den doppelten Querschnitt verbreitert ist und etwa an beiden Enden des Bereichs je ein Sackloch angebracht ist und der Dichtungskörper so in die Nut eingelegt ist, daß die beiden Enden in dem Bereich nebeneinander liegen. Dadurch, daß die Enden des Dichtungskörpers in dem Bereich nebeneinanderliegen, wird mit Sicherheit eine Lücke in dem durch den Dichtungskörper gebildeten Ring vermieden.

Um den Dichtungskörper einerseits einfacher in die Nut einlegen und darin festhalten zu können und andererseits noch zuverlässiger zu erreichen, daß sich keine losen Drahtenden von den Schnittstellen des Dichtungskörpers lösen und aus den Sacklöchern herausgelangen, ist es zweckmäßig, daß die Sacklöcher vor dem Einführen der Enden des Dichtungskörpers mit Klebstoff versehen sind. Insbesondere bei Verwendung einer ausreichenden Menge eines im wesentlichen flüssigen Klebstoffs werden dann alle eventuell losen Drahtenden erfaßt.

Ausführungsbeispiele der Erfindung werden nachstehend anhand der Zeichnung erläutert. Es zeigen:

Fig. 1 zwei Gehäuseteile mit einer Nut zur Aufnahme des Dichtungskörpers in einem Gehäuseteil,

Fig. 2 die Stelle der Nut, an der die Enden des Dichtungskörpers in Sacklöcher eingesteckt sind,

Fig. 3 einen Längsschnitt durch die Nut an dieser Stelle,

Fig. 4 den Bereich der Nut, an dem die beiden Enden des Dichtungskörpers ein Stück nebeneinander geführt und dann in Sacklöcher eingesteckt sind,

Fig. 5 einen Querschnitt durch diesen Bereich.

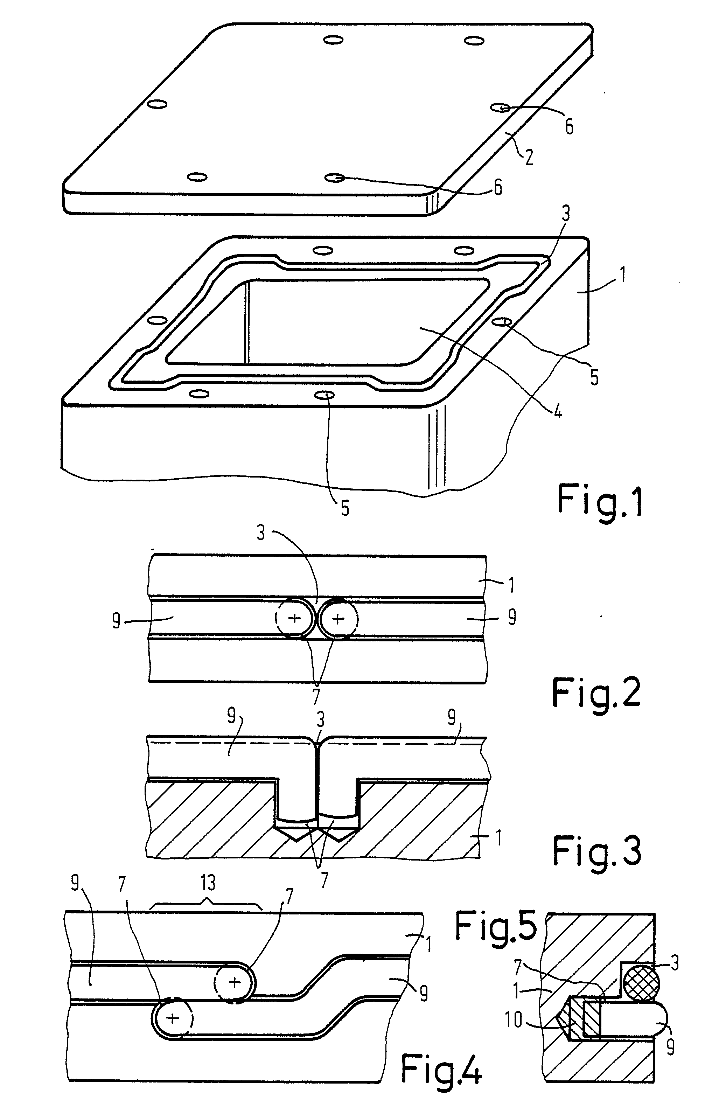

In Fig. 1 ist von einem Gehäuseteil 1 der Bereich dargestellt, auf den ein Deckel 2 befestigt werden soll. Dies geschieht mittels Schrauben durch Löcher 6 im Deckel, die beispielsweise in Gewindebohrungen 5 eingeschraubt werden. In dem offenen Bereich 4 des Gehäuseteils 1 ist eine nicht dargestellte elektronische Schaltungsanordnung eingebaut.

In die Oberfläche des Gehäuseteils 1 ist eine Nut 3 eingebracht, beispielsweise durch Fräsen, die um den gesamten Rand des Gehäuseteils 1 in Form eines geschlossenen Ringes verläuft. In diese Nut 3 wird ein Strang aus leitendem Drahtgewirk als Dichtungskörper eingelegt, der über die Oberfläche des Gehäuseteils 1 hinausragt, so daß beim Aufschrauben des Deckels 2 zwischen dem Gehäuseteil 1 und dem Deckel 2, die beide aus elektrisch leitendem Material bestehen, über den Dichtungskörper an sehr vielen Punkten mit geringem Abstand elektrisch leitende Verbindungen hergestellt werden. Dadurch ist eine hochfrequenzmäßige Abdichtung gewährleistet.

Der Dichtungskörper, der in die Nut 3 eingelegt wird, besteht aus einem Strang aus Drahtgewirk bzw. aus einem Strang weichelastischen Materials, das mit einem Schlauch aus Drahtgewirk überzogen ist. Dieser Strang wird von einem längeren Stück genau auf Maß geschnitten und in die Nut eingelegt. Fig. 2 zeigt ein Beispiel für die Ausbildung der Nut an der Stelle, an der die beiden Schnittenden des Dichtungskörpers 9 in der Nut 3 im Gehäuseteil 1 zusammenstoßen, und zwar sind an dieser Stelle zwei Sackbohrungen 7 in der Nut 3 angebracht, in die die beiden Enden des Dichtungskörpers 9 eingesteckt werden. Dies ist an dem Längsschnitt durch die Nut 3, der in Fig. 3 dargestellt ist, noch deutlicher zu erkennen.

Wenn die beiden Enden des Dichtungskörpers 9 sehr scharf abgeknickt in die Sacklöcher 7 gesteckt werden, berühren sie sich gegenseitig bis zu einer Höhe, die etwa bis zum Rand der Nut 3 hinaufreicht, so daß beim Aufsetzen des Deckels nahezu keine Lücke in der Abschirmung entstehen kann.

Wenn jedoch eine solche Lücke ganz zuverlässig vermieden werden soll, kann eine Ausführung verwendet werden, die in Fig. 4 dargestellt ist. Dort ist die Nut 3 in einem Bereich 13 auf im wesentlichen den doppelten Querschnitt verbreitert, indem der rechte Teil der Nut 3 um etwa eine Nutbreite versetzt an den linken Teil der Nut vorbeigeführt ist. Dadurch werden die beiden Enden eines eingelegten Dichtungskörpers 9 im Bereich 13 parallel geführt, und sie enden in je einem Sackloch 7 an den Enden dieses Bereiches. Dieser Bereich kann auch dadurch gebildet werden, daß die Richtung der linken Nut im Bereich 13 nach oben und die Richtung der rechten Nut nach unten abknickt. Wesentlich ist, daß in dem Bereich 13 durch die Form der Nut 3 die beiden Enden des Dichtungskörpers zumindest für ein kurzes Stück unmittelbar parallel geführt werden, so daß sich diese beiden Enden berühren und in ihrem Verlauf überlappen. Der in Fig. 5 dargestellte Querschnitt durch den Bereich 13 und das eine Sackloch 7 zeigt deutlich, wie sich die beiden Enden des Dichtungskörpers 9 berühren.

Um den Dichtungskörper 9 leichter in der Nut 3 fixieren zu können, d.h. um zu verhindern, daß die Enden des Dichtungskörpers 9 vor dem Aufsetzen des Deckels aus den Sacklöchern herausgleiten, und um gleichzeitig zu erreichen, daß lose Drahtteile von den Schnittstellen des Dichtungskörpers 9 an die Oberfläche des Gehäuseteils 3 gelangen können, ist das Sackloch 7 im Bereich 10 mit einem Klebstoff versehen, der die Enden des Dichtungskörpers 9 im Sackloch 7 und gleichzeitig auch eventuelle lose Drahtteile darin festhält.

## Ansprüche

1. Dichtungsanordnung aus einem strangförmigen elastischen Dichtungskörper mit im wesentlichen konstantem Querschnitt, der mindestens an der Oberfläche aus einem leitenden Drahtgeflecht, insbesondere einem auftragenden Gewirk besteht, und der von einem längeren Stück abgeschnitten ist und der zwischen zwei Gehäuseteilen in eine in der Oberfläche des einen Gehäuseteils angebrachte Nut eingelegt ist, dadurch gekennzeichnet, daß die beiden Enden des Dichtungskörpers (9) in je ein im wesentlichen senkrecht zur Oberfläche des einen Gehäuseteils (1) gerichtetes Sackloch (7) im Bereich der Nut (3) eingesteckt sind.

2. Dichtungsanordnung nach Anspruch 1 mit einer Nut mit ringförmig geschlossenem Verlauf, dadurch gekennzeichnet, daß die Sacklöcher (7) unmittelbar hintereinander in der Nut (3) angeordnet sind.

3. Dichtungsanordnung nach Anspruch 1 mit einer Nut mit ringförmig geschlossenem Verlauf, dadurch gekennzeichnet, daß die Nut (3) in einem Bereich (13) auf etwa den doppelten Querschnitt verbreitert ist und etwa an beiden Enden des Bereichs (13) je ein Sackloch (7) angebracht ist und der Dichtungskörper (9) so in die Nut (3) eingelegt ist, daß die beiden Enden in dem Bereich (13) nebeneinander liegen.

4. Dichtungsanordnung nach einem der Ansprüche 1 bis 3, dadurch gekennzeichnet, daß die Sacklöcher (7) vor dem Einstecken der Enden des Dichtungskörpers (9) mit Klebstoff (10) versehen sind.

Fig.1

Fig.2

Fig.3

Fig.4

Fig.5